# EUROPÄISCHE PATENTANMELDUNG

(11) **EP 2 149 794 A2**
(43) Veröffentlichungstag der Anmeldung: **03.02.2010**
(21) Anmeldenummer: 09166328.6
(22) Anmeldetag: 24.07.2009
(51) Int. Cl.: G01R 15/18, G01R 1/44, G01R 31/02

(54) **Verfahren zum Messen der Stromstärke eines Wechselstromes**

(30) Priorität: 28.07.2008 DE 102008035074
(71) Anmelder: Siemens Aktiengesellschaft, 80333 München (DE)
(72) Erfinder: Niemann, Hartmut, 91056 Erlangen (DE)

(57) **Zusammenfassung**

Die Erfindung betrifft ein Verfahren zum Messen der Stromstärke eines Wechselstromes mit einem Stromwandler (2), der eine Messwicklung (3) und eine Testwicklung (4) aufweist. Es ist vorgesehen, dass der Widerstand der Testwicklung (4) gemessen wird, dass daraus die Temperatur der Testwicklung (4) und damit der Messwicklung (3) bestimmt wird und dass mit dieser Temperatur der an der Messwicklung (3) gemessene Wert für die Stromstärke korrigiert wird.

## Beschreibung

Die Erfindung betrifft ein Verfahren zum Messen der Stromstärke eines Wechselstromes mit einem Stromwandler, der eine Messwicklung und eine Testwicklung aufweist.

Es ist bekannt, dass in die Testwicklung ein Wechselstrom eingeleitet wird, um dann einen Komponentenausfall, z. B. einen Leitungsbruch, erkennen zu können.

Ein solcher Stromwandler entspricht in seinem Aufbau der als solche bekannten Rogowskispule. Bei einer Rogowskispule wird die in der Messwicklung gemessene Stromstärke dahingehend korrigiert, dass sie nicht mehr von der Umgebungstemperatur der Rogowskispule abhängt.

Eine zuverlässige Kompensation des Einflusses der Temperatur ist besonders dann wichtig, wenn das Verfahren zum Messen der Stromstärke eines Wechselstromes bei der Eisenbahntechnik eingesetzt wird. Dort sind stark voneinander abweichende Temperaturen zu erwarten, da die gleiche Technologie in verschiedenen Ländern und auch zu verschiedenen Jahreszeiten eingesetzt wird.

Der Erfindung liegt die Aufgabe zugrunde, ein Verfahren zum Messen der Stromstärke eines Wechselstromes anzugeben, das mit einfachen und trotzdem zuverlässigen Mitteln die Abhängigkeit der an der Messwicklung ausgeführten Messungen von der Temperatur ausschließt oder zumindest minimiert.

Die Aufgabe wird gemäß der Erfindung dadurch gelöst, dass der Widerstand der Testwicklung gemessen wird, dass daraus die Temperatur der Testwicklung und damit der Messwicklung bestimmt wird und dass mit dieser Temperatur der an der Messwicklung gemessene Wert für die Stromstärke korrigiert wird.

Mit dem Verfahren nach der Erfindung wird der Vorteil erzielt, dass mit einfachen Mitteln verhindert wird, dass unterschiedliche Temperaturen auf die gemessene Stromstärke des Wechselstromes einen Einfluss haben können. Temperaturschwankungen, die z. B. an einer Eisenbahnstrecke sehr stark sind, werden vorteilhaft kompensiert.

Beispielsweise wird in die Testwicklung ein Wechselstrom eingespeist, dessen Stromstärke und dessen Spannung gemessen werden. Daraus wird in bekannter Weise der Widerstand bestimmt und aus dem Widerstand wird mittels einer bekannten Abhängigkeitsfunktion die Temperatur bestimmt.

Das Bestimmen der Temperatur erfolgt also in einfacher Weise allein aus der Messung einer Stromstärke und einer Spannung. Aus Stromstärke und Spannung wird nach dem Ohmschen Gesetz der Widerstand bestimmt, der durch die bekannte Funktion von der Temperatur abhängt. Mit Hilfe dieser Funktion ist es möglich, aus dem Widerstand die Temperatur zu bestimmen.

Beispielsweise wird der an der Messwicklung gemessene Wert für die Stromstärke mit einem Schwellwert verglichen, der von der bestimmten Temperatur abhängt, wobei dann die gemessene Stromstärke nur bei Überschreiten des Schwellwertes beachtet wird.

Bei Überschreiten des Schwellwertes kann ein Alarm ausgelöst oder eine Schalthandlung durchgeführt werden.

Vor dem Vergleich mit einem Schwellwert kann der Wert für die Stromstärke durch eine Filterfunktion, z. B. mittels eines Bandpassfilters, korrigiert werden.

Mit der Verwendung eines Schwellwertes wird der Vorteil erzielt, dass die Temperaturabhängigkeit der in der Messwicklung gemessenen Stromstärke mit einfachen Mitteln zuverlässig noch besser kompensiert wird. Man erhält stets einen Stromstärkewert, der nicht durch die Temperatur beeinflusst ist.

Das ist besonders dann vorteilhaft, wenn, wie bei der Eisenbahntechnik üblich, die Umgebungstemperatur abhängig von Zeit und Ort stark schwanken kann und gleichzeitig die dadurch bedingte Änderung des Stromstärkewertes zu einer Einschränkung der Verfügbarkeit der Fahrzeuge bis hin zum Abschalten führt.

Beispielsweise wird die Abhängigkeit des Schwellwertes von der Temperatur nach einer in Labormessungen bestimmten Funktion bestimmt. Diese Funktion kann so erstellt werden, dass eine Temperaturabhängigkeit der Stromstärkemessung an einem Stromwandler zuverlässig zu kompensieren ist.

Beispielsweise wird die Veränderung des Schwellwertes, die zum Beispiel gemäß der in Labormessungen bestimmten Funktion erfolgt, in einer Auswerteeinheit eines Störstromüberwachungsmoduls vorgenommen.

Beispielsweise dient zum Bestimmen der Stromstärke des Stromes durch die Testwicklung ein Widerstand, der in einem Störstromüberwachungsmodul integriert ist.

Mit beiden Weiterbildungen wird der Vorteil erzielt, dass außer dem Widerstand keine bisher noch nicht vorhandenen, zusätzlichen Bauteile notwendig sind.

Es wird der Vorteil erzielt, dass für eine Störstromüberwachung, die mit Hilfe des Stromwandlers einen Störstrom in einer Leitung erfasst, weitgehend vorhandene Bauteile verwendet werden.

Beispielsweise ist der Wechselstrom, dessen Stromstärke gemessen wird, der Oberstrom oder der Rückstrom eines Schienenfahrzeuges.

Um einen Störstrom zuverlässig zu erkennen, wird mit dem Verfahren nach der Erfindung die Stromstärke des Stromes, der durch die Messwicklung des Stromwandlers fließt, nachdem diese Stromstärke durch eine Filterfunktion, z. B. mittels eines Bandpassfilters, korrigiert und die Temperaturabhängigkeit kompensiert worden ist, mit dem Schwellwert verglichen. Eine Überschreitung ergibt dann einen Hinweis auf einen vorhandenen Störstrom.

Beispielsweise ist dieser Schwellwert bei sehr niedriger Umgebungstemperatur größer als sonst, damit bei niedrigen Temperaturen an der Eisenbahnstrecke, insbesondere bei Eisbildung oder Nässe, nicht zu viele Störstrome angezeigt werden, die nur auf die Wetterbedingungen zurückzuführen sind.

Mit dem Verfahren zum Messen der Stromstärke eines Wechselstromes mit einem Stromwandler nach der Erfindung wird insbesondere der Vorteil erzielt, dass bei der Messung der Stromstärke keine unerwünschten Einflüsse der Umgebungstemperatur vorkommen können.

Das Verfahren eignet sich besonders gut zum Erkennen von Störströmen, insbesondere in einer Leitung, die Teil einer Bahnstrecke oder Teil eines Schienenfahrzeuges ist.

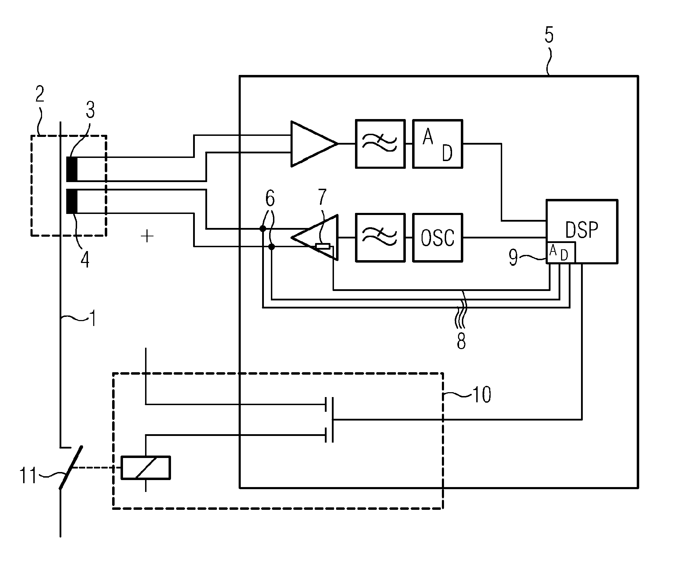

Ein Ausführungsbeispiel für das Verfahren zum Messen der Stromstärke eines Wechselstromes mit einem Stromwandler wird anhand der Zeichnung näher erläutert.

Die Zeichnung zeigt eine Leitung 1, in der ein Störstrom auftreten kann. Zum Erkennen eines Störstromes dient ein Stromwandler 2, der eine Messwicklung 3 und eine Testwicklung 4 aufweist. Beide Wicklungen stehen mit einem Störstromüberwachungsmodul 5 in Verbindung. Um die in der Messwicklung 3 induzierte Stromstärke von ihrer Temperaturabhängigkeit zu befreien, wird die Spannung an der Testwicklung 4 über einen Spannungsabgriff 6 gemessen. Zum Bestimmen der Stromstärke in der Testwicklung 4 dient dann ein in deren Stromkreis eingefügter bekannter Widerstand 7, an dem der Spannungsabfall gemessen wird. Sowohl der Spannungsabgriff 6 als auch der Widerstand 7 stehen über Datenleitungen 8 mit einer Auswerteeinheit 9 innerhalb des Störstromüberwachungsmoduls 5 in Verbindung. Aus der Stromstärke und der Spannung wird der elektrische Widerstand der Testwicklung 4 bestimmt, der mit der Außentemperatur korreliert ist. Zum Bestimmen der Funktion dieser Korrelation werden Labormessungen der elektrischen Widerstände bei unterschiedlichen Temperaturen durchgeführt. Mittels dieser Funktion wird aus dem gemessenen elektrischen Widerstand die momentane Außentemperatur bestimmt. In der Auswerteeinheit 9 steht also ein Wert für die momentane Außentemperatur zur Verfügung, aus der ein Schwellwert bestimmt wird. Auch dazu dient eine in Labormessungen bestimmte Funktion, die eine Abhängigkeit der Stromstärke des Schwellwertes von der Temperatur angibt. Nur, wenn dieser Schwellwert überschritten ist, wird die von der Messwicklung gemessene Stromstärke beachtet und es wird durch die Auswerteeinheit 9 eine Schaltvorrichtung 10 aktiviert, die einen Schalter 11 in der Leitung 1 öffnet. Dadurch wird die Leitung 1 unterbrochen. Einflüsse der Außentemperatur werden beim Erkennen eines Störstromes nach der Erfindung vorteilhaft berücksichtigt.

Beispielsweise wird bei einer niedrigeren Außentemperatur der Schwellwert erhöht, weil bei niedrigerer Temperatur der Kontakt zwischen Rädern und Schiene in der Regel schlechter ist als bei höherer Temperatur, weshalb Abweichungen bei der Stromstärke in der Messwicklung 3 auftreten können, die nicht auf einen Störstrom zurückgehen.

## Patentansprüche

1. Verfahren zum Messen der Stromstärke eines Wechselstromes mit einem Stromwandler (2), der eine Messwicklung (3) und eine Testwicklung (4) aufweist, **dadurch gekennzeichnet, dass** der Widerstand der Testwicklung (4) gemessen wird, dass daraus die Temperatur der Testwicklung (4) und damit der Messwicklung (3) bestimmt wird und dass mit dieser Temperatur der an der Messwicklung (3) gemessene Wert für die Stromstärke korrigiert wird.

2. Verfahren zum Messen der Stromstärke eines Wechselstromes nach Anspruch 1, **dadurch gekennzeichnet, dass** in die Testwicklung (4) ein Wechselstrom eingespeist wird, dass dessen Stromstärke und dessen Spannung gemessen werden, dass daraus der Widerstand bestimmt wird und dass mittels einer bekannten Abhängigkeitsfunktion aus dem Widerstand die Temperatur bestimmt wird.

3. Verfahren zum Messen der Stromstärke eines Wechselstromes nach Anspruch 1 oder 2, **dadurch gekennzeichnet, dass** der an der Messwicklung (3) gemessene Wert für die Stromstärke mit einem Schwellwert verglichen wird, der von der bestimmten Temperatur abhängt, und dass die gemessene Stromstärke nur bei Überschreiten des Schwellwertes beachtet wird.

4. Verfahren zum Messen der Stromstärke eines Wechselstromes nach Anspruch 3, **dadurch gekennzeichnet, dass** die Abhängigkeit des Schwellwertes von der Temperatur nach einer in Labormessungen bestimmten Funktion bestimmt wird.

5. Verfahren zum Messen eines Wechselstromes nach einem der Ansprüche 3 oder 4, **dadurch gekennzeichnet, dass** die Veränderung des Schwellwertes in einer Auswerteeinheit (9) eines Störstromüberwachungsmoduls (5) vorgenommen wird.

6. Verfahren zum Messen der Stromstärke eines Wechselstromes nach einem der Ansprüche 2 bis 5, **dadurch gekennzeichnet, dass** zum Bestimmen der Stromstärke des Stromes durch die Testwicklung (4) ein Widerstand (7) dient, der in einem Störstromüberwachungsmodul (5) integriert ist.

7. Verfahren zum Messen der Stromstärke eines Wechselstromes nach einem der Ansprüche 1 bis 6, **dadurch gekennzeichnet, dass** der Wechselstrom der Oberstrom oder der Rückstrom eines Schienenfahrzeuges ist.
